# EUROPÄISCHE PATENTSCHRIFT

(11) **EP 0 432 090 B1**
(45) Veröffentlichungstag und Bekanntmachung des Hinweises auf die Patenterteilung: **18.01.1995**
(21) Anmeldenummer: 90810864.0
(22) Anmeldetag: 09.11.1990
(51) Int. Cl.: C23C 14/32, C23C 14/06, C23C 14/02

(54) **Verfahren zur Herstellung einer Beschichtung und Werkstück beschichtet nach dem Verfahren**
Process for producing a coating and articles coated by the process
Procédé de production d'un revêtement et article revêtu par le procédé

(30) Priorität: 22.11.1989 CH 4192/89
(43) Veröffentlichungstag der Anmeldung: 12.06.1991
(73) Patentinhaber: BALZERS AKTIENGESELLSCHAFT, 9496 Balzers (LI)
(72) Erfinder: Ramm, Jürgen, Dr., CH-7306 Flaesch (CH); Daxinger, Helmut, CH-7323 Wangs (CH); Buhl, Rainer, Dr., CH-7320 Sargans (CH); Bergmann, Erich, Dr., CH-8887 Mels (CH)
(74) Vertreter: Keller, René, Dr.

(56) Entgegenhaltungen:
- EP-A- 0 166 708
- EP-A- 0 385 283
- EP-A- 0 413 853
- DE-A- 3 428 951
- DE-A- 3 543 316
- DE-C- 3 700 633
- US-A- 4 428 808

## Beschreibung

Die Erfindung betrifft ein Verfahren zur Herstellung einer Beschichtung, gemäß dem Oberbegriff des Patentanspruchs 1 sowie ein chirurgisches Instrument, ein Implantat, einen Wälzkörper und ein Trenn- und Schneidwerkzeug für organisches Material, wie sie in den Patentansprüchen 14 bis 17 beschrieben sind.

Das Aufbringen einer keramischen Schicht aus Oxiden, Nitriden, Oxinitriden und Carbiden auf einem Werkstück (Substrat) ist aus der CH-PS 664 163 bekannt. Bei dem bekannten verfahren wurde in einer Vakuumkammer mittels eines Niedervoltbogens aus einem Tiegel ein Oxid- oder Nitridbildner in einer Stick- oder Sauerstoffatmosphäre verdampft. Das Werkstück wurde auf einem Halter elektrisch isoliert gehalten. Infolge der während des Betriebs der Anlage aufrechterhaltenen elektrischen Gasentladung lud sich der Halter mit den Werkstücken während der Kondensation des Dampfes auf ein negatives Potential auf, was bewirkte, daß positive Ionen aus dem aktiven Dampf und dem Restgas (Plasma) auf die Werkstücke hin beschleunigt wurden.

Ein weiteres Verfahren zum Aufbringen einer keramischen Bornitridschicht ist aus der Veröffentlichung von K. Inagawa et al., "Preparation of cubic boron nitrid film by activated reactive evaporation with a gas activation nozzle", J.Vac.Sci.Technol.A 5 (4), Jul/Aug 1987, pp. 2696 - 2700, bekannt. An eine Gaseinlaßöffnung wurde eine positive Spannung angelegt, um das für die Erzeugung der keramischen Schicht verwendete reaktive Gas zu aktivieren. Ferner wurde eine Wechselspannung im Zehnmegahertzbereich an die Werkstücke angelegt, um die Ionen des eingelassenen Gases auf die Werkstücke zu beschleunigen.

Weitere reaktive physikalische Beschichtungsverfahren (reaktives PVD) zum Aufbringen einer keramischen Zwischenschicht sind z. B. aus der DE-A 34 28 951 und der EP-A 0 166 708 bekannt.

Mit dem bekannten verfahren ließen sich isolierende Schichten sowohl auf leitende, wie auch auf elektrisch isolierende Substrate aufbringen, jedoch ließ die Haftfähigkeit zu wünschen übrig. Wurde mit einer Wechselvorspannung an den Werkstücken gearbeitet, so mußte für eine ausreichende hochfrequenzmäßige Abschirmung der Anlage gesorgt werden; ebenfalls mußte der Abschlußwellenwider stand, der sich mit der Form, Größe und Anzahl der Werkstücke änderte, in einer zeitaufwendigen Prozedur an den des Generators zur Erzeugung der Wechselspannung angeglichen werden.

Der Erfindung liegt die Aufgabe zugrunde, eine gut haftende Beschichtung auf einem Grundkörper eines Werkstücks zu schaffen, wobei diese Beschichtung auch als Trennschicht für eine auf ihr aufgebrachte Oberschicht dienen kann, und der Grundkörper durch diese Trennschicht in einer aggressiven, korrosiven Umgebung verwendbar ist.

Die erfindungsgemäße Lösung der Aufgabe ist hinsichtlich des Verfahrens durch die im Anspruch 1 und hinsichtlich des chirurgischen Instruments, des Implantats, des Wälzkörpers sowie des Trenn- oder Schneidwerkzeugs durch die Ansprüche 14 bis 17 angegebenen Merkmale gekennzeichnet.

Die Ansprüche 2 bis 12 beschreiben bevorzugte Ausführungsarten des erfindungsgemäßen Verfahrens.

Im folgenden wird ein Beispiel des erfindungsgemäßen Verfahrens anhand der Herstellung einer dekorativen Beschichtung mit Zeichnungen näher erläutert. Die Herstellung von Beschichtungen auf Werkstückgrundkörpern zur deren Einsatz als chirurgisches Instrument, Implantat im menschlichen Körper, als Trenn- und Schneidwerkzeug für organisches Material sowie als ohne Öl- und Fettkorrosionsschutz verwendbaren Wälzkörper wird anschließend erläutert. Es zeigen:
- Fig. 1: einen schematischen Schnitt durch eine Beschichtung mit Dekorschicht und keramischer Trennschicht eines Werkstücks,
- Fig. 2: einen schematischen Schnitt durch eine Beschichtung mit Dekorschicht, keramischer Trennschicht und galvanischer Schicht,
- Fig. 3: einen Schnitt durch eine schematische dargestellte Aufdampfanlage, und
- Fig. 4: einen Schnitt durch die Aufdampfanlage in Figur 3 entlang der Linie IV - IV, wobei aufgrund einer vorhandenen Rotationssymmetrie nur eine Hälfte der Aufdampfanlage dargestellt ist.

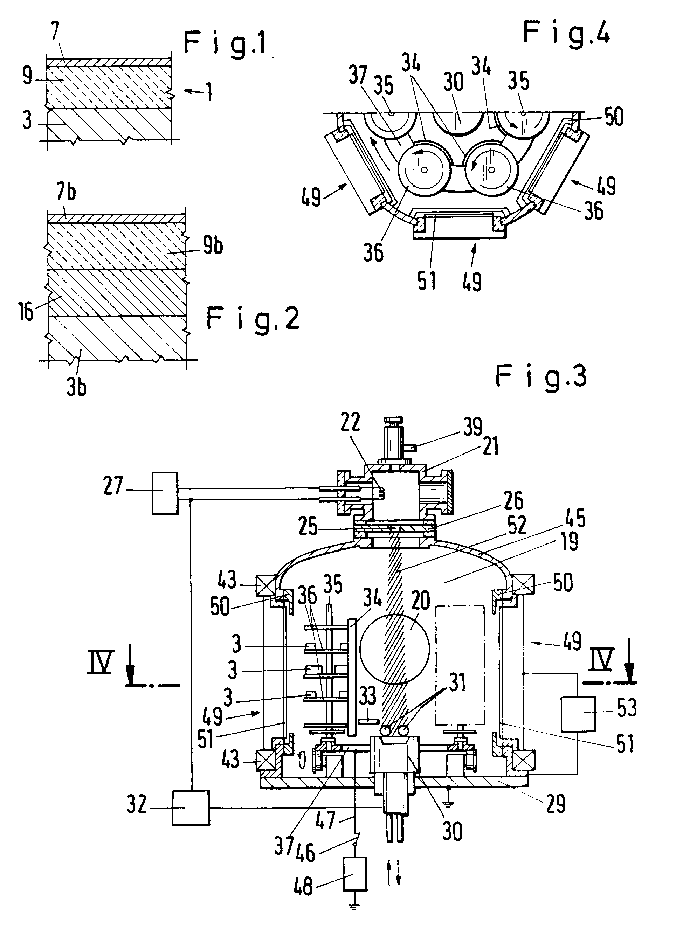

Eine in **Figur 1** dargestellte Dekorschicht **7** liegt auf einer Trennschicht **9** aus elektrisch nicht leitendem, keramischem Materiai über der Oberfläche eines Grundkörpers **3**. Die nach dem unten beschriebenen Verfahren aufgebrachte Trennschicht **9** ist röntgenamorph, d. h. sie zeigt bei Bestrahlung mit einem Röntgenstrahl auf der der Röntgenquelle abgewandten Seite der Trennschicht **9** nur eine annähernd gaußsche Intensitätsverteilung mit einem Strahlungsmaxima in der Strahlmitte; es ist keine Fernfeldordnung (kein Debye-Scherrer- Diagramm) zu erkennen. Eine röntgenamorphe Beschichtung wird durch eine tiefe Beschichtungstemperatur erreicht. Eine tiefe Beschichtungstemperatur ergibt sich, indem die beim unten beschriebenen Verfahren verwendeten elektrischen Leistungen so niedrig gehalten werden, daß keine Kristallbildung erfolgt.

Die Dekorschicht **7** als oberste Schicht besteht im wesentlichen aus Gold.

Die Trennschicht **9** besteht aus einem elektrisch nicht leitendem, keramischen Material, dessen Schichtdicke je nach verwendetem Material und Einsatzgebiet zwischen 0,2 und 5 »m liegt. Unter einem keramischen Material wird eine chemische Verbindung verstanden, die in ihrer soliden Form als Keramik bekannt ist, d. h. der Aufbau der Trennschicht **9** kann somit auch amorph sein. Die Trennschicht **9** enthält im wesentlichen Siliziumnitrid Si₃N₄ und Siliziumoxid SiO₂, wie unten beschrieben.

**Figur 3** zeigt eine schematische Darstellung einer beispielsweisen Aufdampfanlage zur Erzeugung einer dekorativen Beschichtung mit dem erfindungsgemäßen Verfahren. Die Aufdampfanlage hat eine Vakuumkammer **19** mit einem Evakuierungsanschluß **20** und eine Glühkathodenkammer **21** mit einer Glühkathode **22**, die über eine Öffnung **25** mit der Vakuumkammer **19** verbunden ist. Der die Öffnung **25** beinhaltende Boden **26** der Glühkathodenkammer **21** ist gegenüber den Wänden der Vakuumkammer **19** elektrisch isoliert. Die Glühkathode **22** wird von einem Stromversorgungsgerät **27** gespeist. Unterhalb der Öffnung **25** befindet sich über dem Boden **29** der Vakuumkammer **19** ein kühlbarer Tiegel **30**, in dem Silizium **31** als Nitridbildner liegt. Das Silizium **31** ist mit einer verschiebbaren Blende **33** abdeckbar. In der Vakuumkammer **19** sind sechs um die Längsachse drehbare, elektrisch leitende Träger **35**, von denen vier in **Figur 4** angedeutet sind, vorhanden, an denen die zu beschichtenden Grundkörper **3** aus Stahl an je einer Halterung **36** gehalten werden. Die Träger **35** sind um ihre Achse drehbar auf einem Drehteller **37** angeordnet und durch diesen untereinander elektrisch verbunden. Der Drehteller **37** ist gegenüber dem Boden **29** und den Wänden der Vakuumkammer **19** elektrisch isoliert. Die Halterungen **36** sind mit den Trägern **35** elektrisch leitend verbunden. Die an den Halterungen **36** gehaltenen Grundkörper **3** sind mit einer in **Figur 3** und **4** schematisch dargestellten Blende **34** gegenüber dem Silizium **31** im Tiegel **30** abdeckbar.

In die Glühkathodenkammer **21** mündet eine Gaszuleitung **39**, die über die Öffnung **25** mit der Vakuumkammer **19** verbunden ist. Je eine schematisch dargestellte Magnetspule **43** befindet sich gerade oberhalb des Bodens **29** und am Anschluß eines Deckelteils **45** der Vakuumkammer **19** zur Erzeugung eines annähernd parallelen vertikalen Magnetfelds.

Der Drehteller **37** ist über einen nicht dargestellten, gleitenden Kontakt, eine elektrische Leitung **47** und einen geschlossenen Schalter **46** mit einem einstellbaren Spannungsgenerator **48**, dessen anderer Pol geerdet ist, verbunden.

In den vertikalen Wänden der Vakuumkammer **19** sind sechs Vorrichtungen **49** zur Kathodenzerstäubung angeordnet, von denen drei in **Figur 4** dargestellt sind. Die Vorrichtung **49** ist mit einem nicht dargestellten Wärmetauscher zur Kühlung versehen. Innerhalb eines Rings **50** liegt ein von ihm isoliertes Target **51** aus Gold, welches mit dem negativen Pol einer Spannungsquelle **53** verbunden ist. Der positive Pol der Spannungsquelle **53** ist mit den Wänden der Vakuumkammer **19** und dem Ring **50** verbunden. Die Glühkathode **22** und der Tiegel **30** sind über elektrische Leitungen mit einem Stromversorgungsgeräten **27** und **32** verbunden.

Zur Herstellung obiger Beschichtung werden die Grundkörper **3** an den Halterungen **36** der Träger **35** befestigt und Silizium **31** in den Tiegel **30** gelegt. Anschließend wird die Vakuumkammer **19** geschlossen, evakuiert und die zu beschichtenden Oberflächen der Gegenstände **3** entsprechend einem in der DE-OS 34 06 953 bzw. der CH-PS 658 545 beschriebenen Verfahren mit einem Niedervoltbogen **52** erhitzt und entsprechend einem in der CH-PS 631 743 beschrieben Verfahren gereinigt. Die Blende **33** bedeckt währenddessen das Silizium **31** im Tiegel **30**.

Zum Schmelzen des Siliziums **31** wird die Blende **33** derart verschoben, daß das Silizium **31** frei liegt. Die Blende **34** wird vor die Grundkörper **3** geklappt, wie in **Figur 3** dargestellt, um eine Beschichtung mit Silizium bei dessen Schmelzen zu vermeiden. Der Niedervoltbogen **52** brennt jetzt von der Glühkathode **22** zum Silizium **31** im Tiegel **30** mit einer Bogenspannung von 90 V und einem Strom von 60 A, wobei bei Erreichen des Schmelzpunktes die Spannung auf 70 V abfällt und der Strom auf 200 A aufgrund der mit der Temperatur sich erhöhenden Leitfähigkeit des Siliziums **31** ansteigt.

In einem folgenden ersten Verfahrensschritt wird die Stromstärke des Niedervoltbogens **52** auf 200 A bei einer Bogenspannung von 70 V gehalten. Hierdurch wird Silizium **31** aus dem Tiegel **30** in den gasförmigen Zustand überführt und teilweise ionisiert.

In einem zweiten Verfahrensschritt wird in die beim Reinigungsvorgang verwendete Argonatmosphäre Stickstoff durch die Gaszuleitung **39** eingelassen, der durch den Niedervoltbogen **52** teilweise ionisiert wird. Gleichzeitig wird die Blende **34** vor dem Grundkörper **3** weggeklappt. Der teilweise ionisierte Stickstoff und das teilweise ionisierte Silizium vereinigen sich auf der Oberfläche der Grundkörper **3** zu Si₃N₄ und bleiben auf ihr haften. Auch während dieses Verfahrensschritts rotieren die Grundkörper **3**.

Während dieses zweiten Verfahrensschrittes beträgt der Partialdruck des Argons 4·10⁻² Pa und der des Stickstoffs 3·10⁻² Pa. An den Trägern **35** liegt eine pulsierende Gleichspannung mit einer Periodendauer von 10 »s. Zu Beginn dieses Verfahrensschrittes liefert der Spannungsgenerator **48** negative Pulse mit einem Tastverhältnis von 80%, d. h. die Pulsbreite der negativen Pulse beträgt 8 »s bei einer Periodendauer von 10 »s. In den auf die 8 »s folgenden 2 »s sind die Träger **35** über den Spannungsgenerator **48** geerdet. Die Pulshöhe beträgt zu Beginn des Verfahrens - 200V und wird während dieses Verfahrensschritts derart zu kleineren negativen Werten verringert, daß sie gegen Ende bei - 10 V liegt.

Ist eine Schichtdicke der Trennschicht **9** von 1 »m aufgebracht, wird das im Tiegel **30** befindliche Silizium **31** abgedeckt, der Niedervoltbogen **52** und der Spannungsgenerator **32** ausgeschaltet, der Schalter **46** geöffnet und der Stickstoffzufluß unterbrochen. Die Spannungsquelle **53** wird eingeschaltet und hierdurch der Vorgang des Sputterns des Goldes vom Target **51** in Gang gesetzt. Die Grundkörper **3** sind elektrisch floatend. Ist eine Goldschichtdicke von 200 Å auf der Trennschicht **9** niedergeschlagen, wird die Spannungsquelle **53** ausgeschaltet. Die Vakuumkammer **19** wird geflutet und anschließend zur Entnahme der dekorativ beschichteten Gegenstände **1** geöffnet.

Anstelle von Gold lassen sich auch andere Materialien als Dekorschicht **7** sputtern, wie z. B. Silber oder TiOCN für einen schwarzen Belag. Auch kann das Material der Dekorschicht **7** mittels Ionenplattieren mit dem Niedervoltbogen **52** anschließend an das Verdampfen von Silizium **31** verdampft werden. In diesem Fall wird ein (nicht dargestellter) Tiegel mir Silizium und einem weiteren Material, z. B. Titan zur Herstellung einer goldfarbenen Titannitridschicht verwendet. Das jeweils nicht zu verdampfende Material im Tiegel wird dann mit der Blende **33** abgedeckt. Anstelle von Titan können auch andere Metalle verdampft werden, die dann anstelle in einer Stickstoffatmosphäre in einer Sauerstoffatmosphäre zu farbigen Metalloxiden oxydiert werden.

Als Dekorschicht **7** werden hauptsächlich Gold- und Silberschichten mit einer Schichtdicke von mindestens 100 Å oder goldfarbene Verbundbeschichtungen im wesentlichen aus Nitriden der Elemente der Gruppe IVb (Titan, Zirkon, Hafnium) und der Gruppe Vb (Vanadium, Niob, Tantal) oder VIb (Chrom, Molybdän, Wolfram) des Periodensystems, wie in der DE-PS 37 28 836 beschrieben, verwendet. Es kann aber auch eine Hartstoffschicht, in die während des Beschichtungsvorgangs Gold eingelagert wird, verwendet werden. Es werden auch Hartstoffschichten mit eingelagerten farbigen Metalloxiden oder farbige Metalloxyde allein eingesetzt. Die Hartstoffschicht besteht im wesentlichen aus einem Nitrid, Karbid, Oxynitrid, Borid eines Elementes der Gruppe IVb, Vb oder VIb des Periodensystems oder des Siliziums oder deren Mischungen; auch kann eine Hartstoffschicht verwendet werden, die im wesentlichen harten Kohlenstoff iC enthält.

Es kann auch gleichzeitig zum Sputtern des Goldes oder eines anderen Materials eine Ionenplattierung erfolgen, worauf sich als Dekorschicht **7** eine Mischschicht bildet.

Zur Erzeugung einer schwarzen Dekorschicht mit z. B. in einer iC-Matrix eingelagertem Titankarbid wird mittels einer Bogenentladung in einem PVD-Verfahren Titan in einer reaktiven Atmosphäre, die Kohlenstoff abgibt (z. B. Azethylen), verdampft, wobei gegen Ende das Bedampfungsvorgangs der Partialdruck des Kohlenstoff abgebenden Gases zur Erzeugung der iC-Matrix gesteigert wird.

Es kann das Material der keramischen Trennschicht **9** auch mit einem Elektronenstrahl, durch eine Kathodenzerstäubung (Sputtern), eine plasmaunterstütze Verdampfung oder eine kathodische Bogenverdampfung in den gasförmigen Zustand überführt werden.

Statt für die keramische Trennschicht **9** Si₃N₄ zu verwenden, kann auch SiO₂ oder SiₓO_{y}N_{z} verwendet werden. Die keramische Trennschichten **9** aus SiO₂ oder SiₓO_{y}N_{z} wird analog zu dem bereits oben geschilderten Verfahren aufgebracht. Bei keramischen Trennschichten **9** aus SiₓO_{y}N_{z} wird mit einem Partialdruck von 3·10⁻² Pa Argon, 1·10⁻² Pa Sauerstoff und 3·10⁻² Pa Stickstoff gearbeitet. Es kann auch eine Trennschicht **9** aus einem Oxid und/oder Nitrid des Aluminiums, einem Oxid eines Elements der Gruppe IVb (Titan, Zirkon, Hafnium), Vb (Vanadium, Niob, Tantal), VIb (Chrom, Molybdän, Wolfram) oder des Chroms oder aus Mischungen dieser Stoffe oder Mischungen dieser Stoffe mit einem Oxid, Nitrid oder Oxynitrids des Siliziums erfolgen.

Anstelle den nicht mit der Leitung **47** verbundenen Pol des Spannungsgenerators **48** zu erden, kann er auch an den Tiegel **30** oder an Anodenpotential des Niedervoltbogens **52** angeschlossen werden. Anstelle die Pulshöhe von - 200 V auf - 10 V zu verändern, kann auch die Pulsbreite verkleinert werden; es kann auch die Pulsbreite und die Pulshohe verändert werden.

In einer Variante der Aufdampfanlage sind die Halterungen der Grundkörper gegeneinander und gegenüber der Vakuumkammer **19** isoliert. Sie sind direkt über einen (nicht dargestellten) Kontakt und eine elektrische Leitung mit dem einstellbaren Spannungsgenerator **48** verbunden.

Anstelle Stickstoff durch die Gaszuleitung **39** einzulassen, kann auch eine (nicht dargestellte) separate Leitung an einem anderen Ort der Vakuumkammer **19** verwendet werden.

Die Blende **33** wird aus elektrisch isolierendem Material hergestellt oder isoliert gegenüber der Vakuumkammer **19** und dem Tiegel **30** gehaltert. Sie kann aber auch aus einem Material mit einem hochohmigen elektrischen Widerstand bestehen oder mit einer hochohmigen Materialschicht überzogen oder hochohmig mit der Vakuumkammer **19** verbunden sein, um eine elektrische Aufladung, auch aus Sicherheitsgründen, weitgehend zu vermeiden.

Werden mittels der Bogenentladung **52** nacheinander zwei oder mehrere unterschiedliche Materialien in den gasförmigen Zustand übergeführt, so können anstelle der Blende **33** auch mehrere gegeneinander und gegenüber der Vakuumkammer **19** elektrisch isolierte als Werhseltiegel bezeichnete Tiegel verwendet werden, welche je nach Bedarf mit dem einen Pol der Spannungsquelle **32** als Elektrode für die Bogenentladung verbunden werden. Zusätzlich zur Herstellung der jeweiligen elektrischen Verbindung kann der betreffende Wechseltiegel auch noch an einen für die Bogenentladung und die Beschichtungsrate vorteilhaften Ort bewegt werden.

Bei einem zum Grundkörper **3** analogen Grundkörper **3b** aus Messing befindet sich, wie in **Figur 2** dargestellt, eine galvanische Schicht **16** mit einer Schichtdicke von 2 »m aus Nickel direkt auf der Oberfläche des Grundkörpers **3b**. Die galvanische Schicht **16** wird auf die Oberfläche des Grundkörpers **3b** unmittelbar nach dessen Fertigstellung und Oberflächenreinigung aufgebracht, um ein späteres Anlaufen während des Fertigungs- und Transportvorgangs zu vermeiden. Über dieser galvanischen Schicht **16** liegt eine den keramischen Trennschichten **9** entsprechende keramische Trennschicht **9b** und über dieser eine den Dekorschichten **7** entsprechende Dekorschicht **7b**.

Eine Beschichtung erfolgt hier analog zu den bereits oben geschilderten Verfahren mit dem Unterschied, daß hier nicht die Oberfläche des Grundkörpers **3**, sondern die auf ihm haftende galvanische Schicht **16** gereinigt wird.

Bei den erfindungsgemäß beschichteten Grundkörpern **3** erhöht die keramische Trennsschicht namentlich die Korrosionbeständigkeit drastisch. Dieses Ergebnis ist namentlich insofern überraschend, als bis jetzt bei mittels PVD aufgebrachten Schichten gewöhnlich "pin holes", die einer Korrosionsbeständigkeit entgegenwirken, beobachtet wurden.

Da bei dem erfindungsgemäß beschichteten Grundkörper **3** die harte Schicht unterhalb der Dekorschicht liegt, kann zwar bei einem harten Schlag auf den Grundkörper die Trennschicht **9** Risse erhalten. Diese Risse bleiben aber unsichtbar, da sie von der Dekorschicht **7** überdeckt werden. Das dekorative Aussehen wird somit nicht beeinflußt.

Treten große und rasche Temperaturschwankungen bei der Verwendung eines dekorativ beschichteten Gegenstands **12** auf, so wird auf dem Grundkörper **3** zusätzlich zu einer zur Dekorschicht **7** analogen Dekorschicht und einer zur keramischen Trennschicht **9** analogen keramischen Trennschicht eine zusätzliche Schicht unterhalb der keramischen Trennschicht aufgebracht. Der thermische Ausdehnungskoeffizient des verwendeten Materials liegt zwischen dem des Grundkörpers **3** und dem der keramischen Trennschicht. Der Ausdehnungskoeffizient der Dekorschicht muß nicht berücksichtigt werden, da sie dünner als die keramische Trennschicht ist.

Bei einer Dekorschicht mit einer Dicke von 200 Å Gold, einer 1 »m dicken keramischen Trennschicht aus Si₃N₄ und einem Grundkörper **3** aus Stahl St 37 wird beispielsweise eine 0,5 »m dicke thermische Trennschicht aus SiO₂ aufgebracht.

Die thermische Trennschicht wird analog zu den oben geschilderten Verfahren in einer analogen oder gleichen Aufdampfanlage aufgebracht.

Es wird jedoch nach dem Reinigen und Aufheizen nicht sofort Stickstoff, sondern Sauerstoff eingeleitet und ebenfalls Silizium mit dem Niedervoltbogen verdampft. Auf der Oberfläche der Grundkörper **3** schlägt sich SiO₂ nieder. Es wird mit einem Sauerstoffpartialdruck von 4·10⁻² Pa, einem Argonpartialdruck von 3·10⁻² Pa und einer Spannung des Niedervoltbogens **52** von 65 V bei einem Strom von 160 A gearbeitet. Ist eine Schichtdicke von 0,5 »m aufgewachsen, wird die Sauerstoffzufuhr gestoppt und Stickstoff eingeleitet und entsprechend dem oben beschriebenen Verfahren mit den oben erwähnten Daten für den Niedervoltbogen **52** weitergearbeitet. An die Träger **35** wird ebenfalls eine gepulste Gleichspannung mit einer Periodendauer von etwa 10 »s angelegt, wobei zu Beginn dieses Verfahrensschrittes der Spannungsgenerator **48** negative Pulse mit einer Pulsbreite von 8 »s und einer Amplitude von -200 V und gegen Ende des Beschichtungsvorgangs von SiO₂ und Si₃N₄ von -10 V liefert und in den jeweils folgenden 2 »s die Träger **35** erdet.

Wird anstelle der Dekorschicht **7** eine Hartshicht aufgebracht, die im wesentlichen aus einer Verbindung des Stickstoffs, Koblenstoffs oder Bors mit einem Metall der Gruppe IVb, Vb, VIb oder aus Siliziumkarbid oder Mischungen dieser Stoffe gebildet ist, so eignen sich die derart beschichteten Werkstücke ausgezeichnet als Werkzeug oder Instrumente zum Schneiden und/oder Trennen von organischem Material. Die Werkzeuge lassen sich insbesondere als Vulkanisierformen, Plastikspritzgußformen, Messer zum Bearbeiten von Fleisch und als chirurgische Instrumente, welche zusätzlich eine ausgezeichnete Resistenz gegenüber Desinfektionsmitteln und Sterilisationsvorgängen besitzen, verwenden. Derart beschichtete Gegenstände lassen sich auch mit ausgezeichneten Eigenschaften als Implantate im menschlichen Körper verwenden.

Anstelle der Dekorschicht **7** kann auch eine Gleitschicht aufgebracht werden und die derart beschichteten Werkstücke als Wälzkörper verwendet werden. Die Gleitschicht besteht aus einem Gemisch von in statistischer Verteilung aufgestäubten Teilen aus mindestens einem eine fest zusammengefügt Matrix bildenden metallischen Werkstoff und mindestens einer Art von metallischen Werkstoffpartikeln mit einem statistischen Durchmesser kleiner 0,8 »m und einem niedrigeren Schmelzpunkt als der Matrixwerkstoff. Die Werkstoffpartikel sind im festem Zustand praktisch nicht im Werkstoff der Matrix löslich. Die in der Matrix unlöslichen Werkstoffpartikel bestehen im wesentlichen aus Zinn, Blei, Indium oder Zink. Der die Matrix bildende Werkstoff ist eine Legierung im wesentlichen aus Aluminium, Chrom, Nickel, Magnesium oder Kupfer. Als Gleitschicht lassen sich ferner metallische Chalkogenide (z. B. Niobdiselenid, Molybdändisulfid, Wolframdisulfid) verwenden. Die Gleitschicht hat eine Dicke, die das zwei bis zehnfache der Trennschicht **9** beträgt und wird bevorzugt mittels Kathodenzerstäubung aufgebracht. Aufgrund des ausgezeichneten Korrosionsschutzes durch die Trennschicht **9** kann bei den erfindungsgemäß beschichteten Wälzkörpern auf Öl oder Fett als Korrosionsschutz verzichtet werden. Die für Wälzkörper geforderte hohe Flächenpressung ist bei den erfindungsgemäßen Wälzkörpern gegeben.

Bestehen die Grundkörper, wie oben beschrieben, nicht aus einem elektrisch leitenden Material, sondern aus einem isolierenden Material, wie z. B. aus Glas, so wird die Periodendauer der an die Halterung **36** der Grundkörper gelegten pulsierenden Gleichspannung verringert oder durch eine Wechselspannung entsprechend hoher Frequenz (etwa 13 MHz) ersetzt.

Da bei dem oben beschriebenen erfindungsgemäßen Verfahren mit einer pulsierenden Gleichspannung anstelle einer Wechselspannung gearbeitet wird, kann durch Veränderung der Taktzeit die Zeit, in der die Ionen auf das Werkstück fallen, eingestellt und optimal angepaßt werden; ebenfalls ist die Energie mit der die Ionen "angezogen" werden, einstellbar.

Von der maschinentechnischen Seite her kann eine mit pulsierender Gleichspannung arbeitende Aufdampfanlage einfacher aufgebaut werden, da auf eine Abschirmung der Zuleitung der pulsierenden Gleichspannung zu den Werkstücken im Gegensatz zur bekannten Wechselspannung verzichtet werden kann; auch entfällt das zeitaufwendige Nachstellen des Abschlußwiderstands der elektrischen Zuleitung bei der Verwendung der pulsierende Gleichspannung. Bei der Verwendung einer Wechselspannung mußte der Abschlußwlderstand, der sich durch die Art der Werkstücke, des Halters und deren Anzahl ergab, auf den Wellenwiderstand des Zuleitungskabels angepaßt werden, um eine Leistungsabstahlung zu vermeiden, einen möglichst hohen Amplitudenwert an den Werkstücken zu erhalten und um den Wechselspannungsgenerator nicht zu überlasten.

## Patentansprüche

1. Verfahren zur Herstellung einer Beschichtung mit einem keramischen, elektrisch nicht leitenden Material auf einer Oberfläche eines gegenüber einer Vakuumkammer **(19)** isoliert gehaltenen Grundkörpers **(3)** eines Werkstücks **(1)**, wobei in einem ersten Verfahrensschritt ein Oxid- und/oder Nitridbildner **(31)** in den gasförmigen Zustand übergeführt und wenigstens teilweise ionisiert wird, und in einem zweiten Verfahrensschritt Stickstoff und/oder Sauerstoff eingeleitet und wenigstens teilweise ionisiert wird, worauf sich auf der Oberfläche des Grundkörpers **(3)** eine Schicht **(9)** aus einer Verbindung des Oxid- bzw. Nitridbildner **(31)** und des Stickstoffs und/oder des Sauerstoffs niederschlägt, **dadurch gekennzeichnet**, daß zumindest während des zweiten Verfahrensschritts eine pulsierende Gleichspannung, an den Grundkörper **(3)** und/oder dessen Halter **(36)** gelegt wird.

2. Verfahren nach Anspruch 1, **dadurch gekennzeichnet**, daß das Tastverhältnis der pulsierenden Gleichspannung zwischen 20 und 90%, bevorzugt zwischen 60 und 90% eingestellt wird.

3. Verfahren nach Anspruch 1 oder 2, **dadurch gekennzeichnet**, daß die Periodendauer der pulsierenden Gleichspannung auf einige Mikrosekunden, bevorzugt auf annähernd zehn Mikrosekunden, eingestellt wird.

4. Verfahren nach einem der Ansprüche 1 bis 3, **dadurch gekennzeichnet**, daß die Pulshöhe der pulsierenden Gleichspannung beginnend mit einem hohen negativen Spannungswert auf einen geringen negativen Wert verändert und zwischen den Pulsen der Grundkörper **(3)** und oder dessen Halter **(36)** geerdet oder auf das Potential des noch nicht in den gasförmigen Zustand überführten Oxid- bzw. Nitridbildners **(31)** oder auf Anodenpotential einer Bogenentladung **(52)** zur Überführung des Oxid- bzw. Nitridbildners **(31)** in den gasförmigen Zustand gelegt wird.

5. Verfahren nach einem der Ansprüche 1 bis 4, **dadurch gekennzeichnet**, daß die aus einer Verbindung des Oxid- bzw. Nitridbildner **(31)** und des Stickstoffs und/oder des Sauerstoffs niedergeschlagene Schicht als Trennschicht **(9)** erzeugt wird, auf die in einem dritten Verfahrensschritt eine Oberschicht **(7)** niedergeschlagen wird.

6. Verfahren nach einem der Ansprüche 1 bis 5, **dadurch gekennzeichnet**, daß zur Überführung des Oxid- und/oder Nitridbildners **(31)** in den gasförmigen Zustand und zu dessen wenigstens teilweiser Ionisierung sowie zur wenigstens teilweisen Ionisierung des Stickstoffs und/oder Sauerstoffs eine Bogenentladung **(52)** verwendet wird.

7. Verfahren nach den Ansprüchen 5 und 6, **dadurch gekennzeichnet**, daß der Oxid- bzw. Nitridbildner **(31)** und ein im dritten Verfahrensschritt in den gasförmigen Zustand zu überführendes Material für die Bildung der Oberschicht **(7)** in je eine Vertiefung eines als Elektrode für die Bogenentladung **(52)** geschalteten, unterteilten Tiegels gelegt. wird, und während des zweiten Verfahrensschrittes das Material für die Bildung der Oberschicht **(7)** und während des dritten Verfahrensschrittes der Oxid- bzw. Nitridbildner **(31)** mit einer Blende **(33)** abgedeckt wird, damit während des zweiten Verfahrensschrittes nur der Oxid- bzw. Nitridbildner **(31)** und während das dritten Verfahrensschrittes nur das Material mittels der Bogenentladung **(52)** in den gasförmigen Zustand übergeführt wird.

8. Verfahren nach den Ansprüchen 5 und 6, **dadurch gekennzeichnet**, daß der Oxid- bzw. Nitridbildner **(31)** und ein im dritten Verfahrensschritt in den gasförmigen Zustand zu überführendes Material für die Bildung der Oberschicht **(7)** in je einen Wechseltiegel gelegt werden, und der Wechseltiegel mit dem Oxid- bzw. Nitridbildner während des zweiten Verfahrensschrittes und der Wechseltiegel mit dem Material für die Bildung der Oberschicht **(7)** während des dritten Verfahrensschrittes als Elektrode der Bogenentladung **(52)** geschaltet, werden, damit während des zweiten Verfahrensschrittes nur der Oxid- bzw. Nitridbildner und während das dritten Verfahrensschrittes nur das Material mittels der Bogenentladung **(52)** in den gasförmigen Zustand übergeführt wird.

9. Verfahren nach einem der Ansprüche 6 bis 8, **dadurch gekennzeichnet**, daß ein Niedervoltbogen **(52)** als Bogenentladung verwendet wird.

10. Verfahren nach einem der Ansprüche 1 bis 9, **dadurch gekennzeichnet**, daß
als Oxid- bzw. Nitridbildner Silizium verwendet wird.

11. Verfahren nach einem der Ansprüche 1 bis 9, **dadurch gekennzeichnet**, daß
als Oxid- bzw. Nitridbildner Aluminium verwendet wird.

12. Verfahren nach Anspruch 5, **dadurch gekennzeichnet**, daß
als Oberschicht eine Verbindung des Stickstoffs, Kohlenstoffs oder Bors mit einem Metall der chemischen Gruppe IVb (Ti, Zr, Hf), Vb (V, Nb, Ta), VIb (G, Mo, W) des Periodensystems oder Siliziumcarbid oder Mischungen dieser Stoffe mit einem PVD-Verfahren aufgebracht wird bzw. werden.

13. Verfahren nach Anspruch 5, **dadurch gekennzeichnet**, daß
als Oberschicht eine Gleitschicht bestehend aus einem Gemisch von in statischer Verteilung aufgestäubten Teilen aus mindestens einem eine fest zusammengefügte Matrix bildenden metallischen Werkstoff und mindestens einer Art von metallischen Werkstoffpartikeln mit einem statistischen Durchmesser kleiner 0,8 »m und einem niedrigeren Schmelzpunkt als dem des Matrixwerkstoffs aufgebracht wird, wobei
die Werkstoffpartikel im festen Zustand praktisch nicht im Matrixwerkstoff löslich sind und die unlöslichen Werkstoffpartikel bevorzugt Zinn, Blei, Indium oder Zink sind.

14. Chirurgisches Instrument mit einem Grundkörper beschichtet nach dem Verfahren gemäß der Patentansprüche 10 und 12 oder 11 und 12 mit einer Trennschichtdicke zwischen 0,2 bis 5 »m.

15. Implantat für den menschlichen Körper mit einem Grundkörper beschichtet nach dem Verfahren gemäß der Patentansprüche 10 und 12 oder 11 und 12 mit einer Trennschichtdicke zwischen 0,2 bis 5 »m.

16. Wälzkörper mit einem Grundkörper beschichtet nach dem Verfahren gemäß der Patentansprüche 10 und 13 mit einer gegenüber der Trennschicht zwei- bis zehnfach dickeren Oberschicht, wodurch
der Wälzkörper ohne Öl und Fett als Korrosionsschutz verwendbar ist.

17. Schneid- oder Trennwerkzeug für organische Materialien mit einem Grundkörper beschichtet nach dem Verfahren gemäß der Patentansprüche 10 und 12 oder 11 und 12 mit einer Trennschicht zwischen 0,2 und 5 »m.

## Claims

1. A method for producing a coating of a non-conducting ceramic material on an upper surface of a base body (3) of a workpiece (1), the base body being kept insulated from a vacuum chamber (19), wherein an oxidant and/or nitride former (31) is converted to a gaseous state and is at least partially ionised in a first step of the method, and nitrogen and/or oxygen is/are introduced and at least partially ionised in a second step of the method, whereby a film (9) comprising a combination of the oxidant or nitride former (31) and the nitrogen and/or oxygen is deposited on the upper surface of the base body (3), characterised in that at least during the second step of the method a pulsed continuous voltage is applied to the base body (3) and/or its container (36).

2. A method in accordance with claim 1, characterised in that the ratio at which the pulsed continuous voltage contacts the base body (3) and/or its container is preferably set between 60 and 90%.

3. A method in accordance with claim 1 or 2, characterised in that the time period of the pulsed continuous voltage is set to several microseconds, preferably to the nearest ten microseconds.

4. A method in accordance with one of claims 1 to 3, characterised in that the pulse height of the pulsed continuous voltage is changed, starting with a high negative voltage value, to a low negative value and is earthed between the pulses to the base body (3) and/or its container (36) or at the potential of the oxidant and/or nitride former (31) not yet converted to the gaseous state or at the anode potential of an arc discharge (52) that will convert the oxidant or nitride former (31) into the gaseous state.

5. A method in accordance with one of claims 1 to 4, characterised in that the deposited layer of a combination of the oxidant or nitride former (31) and the nitrogen and/or oxygen is intended to form a separating layer (9), on which an upper layer (7) will be deposited in a third step of the method.

6. A method in accordance with one of claims 1 to 5, characterised in that an arc discharge (52) is used to convert the oxidant and/or nitride former (3) into the gaseous state and at least partially ionise them as well as at least partially ionise the nitrogen and/or oxygen.

7. A method in accordance with claims 5 and 6, characterised in that the oxidant or nitride former (31) and the material to be converted to the gaseous state to form the upper layer (7) in a third step of the method are each placed in a respective compartment of a sub-divided crucible operating as an electrode for the arc discharge (52) and in that the material for forming the upper layer (7) during the second step and the oxidant or nitride former (31) used for the third step is shielded by a screen (33), so that only the oxidant or nitride former (31) during the second step of the method and only the material during the third step of the method will be converted to the gaseous state by the arc discharge (52).

8. A method in accordance with claims 5 and 6, characterised in that the oxidant or nitride former (31) and the material to be converted to the gaseous state to form the upper layer (7) in the third step of the method are each placed in an exchange crucible, and in that the exchange crucible with the oxidant or nitride former for the second step of the method and the exchange crucible with the material for forming the upper layer (7) during the third step of the method is operated as an electrode of the arc discharge (52), so that only the oxidant or nitride former during the second step of the method and only the material for the third step of the method is converted to the gaseous state by the arc discharge (52).

9. A method in accordance with claims 6 to 8, characterised in that a low voltage arc (52) is used as an arc discharge.

10. A method in accordance with one of claims 1 to 9, characterised in that silicon is used as an oxidant or nitride former.

11. A method in accordance with one of claims 1 to 9, characterised in that aluminium is used as the oxidant or nitride former.

12. A method in accordance with claim 5, characterised in that a combination of nitrogen, carbon or boron with a metal from the chemical group IVb (Ti, Zr, Hf), Vb (V, Nb, Ta), VIb (G, Mo, W) of the Periodic Table or silicon carbide or mixtures of these substances are or will be applied with a PVD-method as an upper layer.

13. A method in accordance with claim 5, characterised in that an additional layer consisting of a mixture of atomised parts in static distribution, of which at least one is a metallic working substance that will form a stable combined matrix and at least one of a metallic type of particulate working substance with a static diameter of less than 0.8 »m and a melting point lower than that of the working substance matrix, will be applied as the upper layer, whereby the particles of the working substance in the stable state are virtually insoluble in the working substance matrix and the insoluble working substances are preferably tin, lead, indium or zinc.

14. A surgical instrument with a base body coated in accordance with the method of patent claims 10 and 12 or 11 and 12 with a separating layer of a thickness of between 0.2 and 5 »m.

15. Implant for the human body with a base body coated in accordance with the method of patent claims 10 and 12 or 11 and 12 with a separating layer of a thickness of between 0.2 and 5 »m.

16. A bearing with a base body coated in accordance with the method of patent claims 10 and 13 with an upper layer two to ten times thicker than the separating layer, wherein the bearing body may be used without oil and lubricant to protect against corrosion.

17. A cutting or separating tool for organic materials with a base body coated in accordance with the method of patent claims 10 and 12 or 11 and 12 with a separating layer of between 0.2 and 5»m.

## Revendications

1. Procédé pour la préparation d'un revêtement avec un matériau céramique non conducteur électriquement sur une surface d'un corps de base (3) maintenu de façon isolée vis-à-vis d'une chambre de vide (19), corps de base d'une pièce à usiner (1), ce en quoi dans une première étape opératoire un agent formateur d'oxyde et/ou de nitrure (31) est amené à l'état gazeux et au moins partiellement ionisé, et au cours d'une deuxième étape opératoire, on introduit de l'azote et/ou de l'oxygène et au moins partiellement ionisé, après quoi à la surface du corps de base (3), une couche (9) provenant d'une liaison de l'agent de formation d'oxyde ou de nitrure (31) et de l'azote et/ou de l'oxygène précipite, caractérisé en ce qu'au moins pendant la deuxième étape opératoire on applique une tension continue pulsante sur le corps de base (3) et/ou son support (36).

2. Procédé selon la revendication 1, caractérisé en ce que le facteur d'utilisation des impulsions de la tension continue pulsante est réglé entre 20 et 90%, de préférence entre 60 et 90%.

3. Procédé selon la revendication 1 ou 2, caractérisé en ce que la durée de période de la tension continue pulsante est réglée sur plusieurs microsecondes, de façon préférée sur approximativement 10 microsecondes.

4. Procédé selon l'une des revendications 1 à 3, caractérisé en ce que la hauteur d'impulsion de la tension continue pulsante en commençant par une valeur de tension négative élevée passe à une valeur négative faible et mise à la terre entre les impulsions du corps de base (3) et/ou de son support (36) ou est appliqué au potentiel de l'agent formateur d'oxyde ou de nitrure (31) non encore transformé en l'état gazeux ou un potentiel d'anode d'une décharge d'arc (52) pour la transformation de l'agent de formation d'oxyde ou de nitrure (31) en l'état gazeux.

5. Procédé selon l'une des revendications 1 à 4, caractérisé en ce que la couche précipitée à partir d'une liaison de l'agent de formation d'oxyde ou de nitrure (31) et de l'azote et/ou de l'oxygène est produite comme couche de séparation (9) sur laquelle précipite une couche supérieure (7) au cours d'une troisième étape opératoire.

6. Procédé selon l'une des revendications 1 à 5, caractérisé en ce que pour la transformation de l'agent de formation d'oxyde et/ou de nitrure (31) en l'état gazeux, et pour son ionisation au moins partielle ainsi que pour l'ionisation au moins partielle de l'azote et/ou de l'oxygène, on utilise une décharge d'arc (52).

7. Procédé selon les revendications 5 et 6, caractérisé en ce que l'agent de formation d'oxyde ou d'azote (31) et un matériau à transformer en l'état gazeux au cours de la troisième étape opératoire pour la formation de la couche supérieure (7) sont respectivement déposés un évidement d'un creuset divisé, monté comme électrode pour la décharge d'arc (52) et au cours de la deuxième étape opératoire, le matériau pour la formation de la couche supérieure (7) et au cours de la troisième étape opératoire, l'agent de formation d'oxyde ou de nitrure (31) est recouvert d'un écran (33) afin que pendant la deuxième étape opératoire, seul l'agent de formation d'oxyde ou de nitrure (31) et au cours de la troisième étape opératoire, seul le matériau sont transformés en l'état gazeux au moyen de la décharge d'arc (52).

8. Procédé selon les revendications 5 et 6, caractérisé en ce que l'agent de formation d'oxyde ou de nitrure (31) et un matériau à transformer en l'état gazeux au cours de la troisième étape opératoire pour la formation de la couche supérieure (7) sont respectivement déposés dans un creuset alternatif, et le creuset alternatif avec l'agent de formation d'oxyde ou de nitrure pendant la deuxième étape opératoire et le creuset alternatif avec le matériau pour la formation de la couche supérieure (7) pendant la troisième étape opératoire servent d'électrode de la décharge d'arc (52), afin que pendant la deuxième étape opératoire, seul l'agent de formation d'oxyde ou de nitrure et pendant la troisième étape opératoire, seul le matériau est transformé au moyen de la décharge d'arc (52), sont transformés en l'état gazeux.

9. Procédé selon l'une des revendications 6 à 8, caractérisé en ce que l'on utilise un arc à basse tension (52) comme décharge d'arc.

10. Procédé selon l'une des revendications 1 à 9, caractérisé en ce qu'en tant qu'agent de formation d'oxyde ou de nitrure, on utilise du silicium.

11. Procédé selon l'une des revendications 1 à 9, caractérisé en ce qu'en tant qu'agent d'oxyde ou de nitrure, on utilise de l'aluminium.

12. Procédé selon la revendication 5, caractérisé en ce qu'en tant que couche supérieure on applique une liaison de l'azote du carbone ou de bords avec un métal de groupes chimiques IVb (Ti, Zr, Hf), Vb (V, Nb, Ta), VIb (G, Mo, W) du tableau des éléments périodiques ou d'un carbure de silicium ou de mélanges de ces substances avec un procédé PVD.

13. Procédé selon la revendication 5, caractérisé en ce qu'en tant que couche supérieure, on applique une couche de glissement constituée par un mélange de particules pulvérisées en division statique à partir d'au moins une substance métallique formant une matrice solidement structurée et au moins un type de particules de matière métallique avec un diamètre statistique inférieur à 0,8 »m et un point de fusion inférieur à celui de la substance de la matrice, ce en quoi les particules de matériau à l'état solide ne sont pratiquement pas solubles dans le matériau de matrice et les particules de matériaux non solubles sont de préférence l'étain, le plomb, l'indium ou le zinc;

14. Instrument chirurgical comportant un corps de base revêtu selon le procédé des revendications 10, 12 au 11 et 12, doté d'une couche de séparation d'une épaisseur entre 0,2 à 5 »m.

15. Implant pour le corps humain comportant un corps de base revêtu selon le procédé des revendications 10 et 12 ou 11 et 12, d'une couche de séparation d'une épaisseur entre 0,2 et 5 »m.

16. Corps de cylindre doté d'un corps de base revêtu selon le procédé des revendications 10 et 13 comportant une couche supérieure égale à 2 jusqu'à 10 fois celle de la couche de séparation, le corps de cylindre pouvant être utilisé comme protection anti-corrosion sans huiles ni graisses.

17. Outil de coupe ou de séparation de matériaux organiques avec un corps de base revêtu, selon le procédé des revendications 10 et 12 ou 11 et 12, d'une couche de séparation d'une épaisseur entre 0,2 et 5 »m.
